# EUROPÄISCHE PATENTSCHRIFT

(11) **EP 3 545 549 B1**
(45) Veröffentlichungstag und Bekanntmachung des Hinweises auf die Patenterteilung: **17.08.2022**
(21) Anmeldenummer: 17702788.5
(22) Anmeldetag: 20.01.2017
(51) Int. Cl.: H01L 23/40, H01L 23/427

(54) **KÜHLPLATTE**
COOLING PLATE
PLAQUE DE REFROIDISSEMENT

(43) Veröffentlichungstag der Anmeldung: 02.10.2019
(73) Patentinhaber: Siemens Energy Global GmbH & Co. KG, 81739 München (DE)
(72) Erfinder: BÖHM, Matthias, 91564 Neuendettelsau (DE)
(86) Internationale Anmeldenummer: PCT/EP2017/051166
(87) Internationale Veröffentlichungsnummer: WO 2018/133942

(56) Entgegenhaltungen:
- WO-A1-2013/044409
- CH-A- 546 480
- US-A- 3 780 356

## Beschreibung

Die Erfindung betrifft eine Kühlplatte zum Kühlen eines in einem Spannverband angeordneten elektrischen Bauelements sowie ein Verfahren zum Kühlen eines derartigen Bauelements.

Die Kühlung von in elektrischen Schaltungen enthaltenen elektrischen Bauelementen (zum Beispiel die Kühlung von Dioden, IGCTs, IGBTs oder Überspannungsableitern wie MetalloxydÜbcrspannungsableitern) ist gewöhnlich für den Normalbetrieb der elektrischen Schaltung ausgelegt. Jedoch kann es zum Beispiel durch defekte Bauelemente oder durch Umwelteinflüsse (wie beispielsweise Blitzschlag) zu kurzzeitig auftretenden lokalen Ereignissen (wie z. B. Überspannungen) kommen, welche eine erhebliche Erwärmung der elektrisch durchströmten Bauelemente zur Folge haben. Die dabei kurzzeitig auftretenden großen Wärmemengen sollten schnellstmöglich von den betroffenen Bauelementen abgeführt werden, um die Funktion der Bauelemente aufrecht zu erhalten. Dies ist insbesondere bei Bauelementen der Hochspannungstechnik wichtig, da bei diesen Bauelementen aufgrund der hohen Spannungen und/oder hohen Ströme sehr schnell große Verlustleistungs-Wärmemengen auftreten können.

Insbesondere bei parallel geschalteten elektrischen Bauelementen ist eine möglichst gleiche Temperatur der parallel geschalteten Bauelemente (und daher eine gute Kühlung dieser Bauelemente) wichtig, da bei unterschiedlich hohen Temperaturen der parallel geschalteten Bauelemente sich der Strom ungleichmäßig auf diese parallel geschalteten Bauelemente verteilen würde. Dies ist insbesondere bei parallel geschalteten Überspannungsableitern wichtig, da bei einer Erhöhung der Temperatur eines der parallel geschalteten Überspannungsableiter dessen elektrischer Widerstand sinken würde und dadurch der Strom durch diesen Überspannungsableiter noch weiter ansteigen würde. Dadurch könnte der betroffene Überspannungsableiter beschädigt werden. Insbesondere bei in einem Spannverband angeordneten elektrischen Bauelementen ist die Kühlung sehr wichtig, da in einem Spannverband auf engem Raum relativ große Verlustleistungs-Wärmemengen entstehen können.

Eine Möglichkeit zum Umgang mit einer kurzzeitig auftretenden großen Wärmemenge wäre, die Kühlung für den Normalbetrieb überdimensioniert auszuführen, so dass auch bei kurzzeitigen Überhitzungen die Wärmeenergie sicher abgeführt werden kann. Eine derartige überdimensionierte Kühlung wäre allerdings mit hohen Kosten verbunden.

Aus dem Patent US 5,831,831 ist ein Kühlkörper bekannt, welcher mit einem Phasenwechselmaterial versehen ist. Dieser Kühlkörper wird auf der Oberseite eines elektronischen Bauelements befestigt, welches auf einer Trägerplatte angeordnet ist. Dadurch kann dieses elektronische Bauelement gekühlt werden. Dieser Kühlkörper ist jedoch ausschließlich für die Kühlung eines auf einer Trägerplatte angeordneten elektronischen Bauelements geeignet, dessen Oberfläche gut zugänglich ist.

Aus der Schrift CH 546 480 A ist eine Einrichtung zur Absorption thermischer Impulse bekannt. Diese Einrichtung weist zwischen einer Wärmequelle und einer Kühleinrichtung einen mit Hohlräumen versehenen Körper auf, dessen Hohlräume zumindest teilweise mit einem Metall gefüllt sind. Dieses Metall weist einen Schmelzpunkt auf, der unterhalb der maximal auftretenden Oberflächentemperatur der Wärmequelle liegt

Aus der Schrift WO 2013/044409 A ist ein Spannverband mit einer Mehrzahl von Kühlplatten und einer Mehrzahl von elektrischen Bauelementen bekannt.

Die Schrift US 3,780,356 offenbart eine Kühleinrichtung für ein Halbleiter-Bauelement. Diese Kühleinrichtung weist eine Kammer mit einem nichtmetallischen kristallbildenden Material auf, welches durch die Betriebstemperatur des HalbleiterBauelements einen Phasenwechsel erfährt.

Der Erfindung liegt die Aufgabe zugrunde, eine Kühleinrichtung und ein Verfahren anzugeben, mit denen ein in einem Spannverband angeordnetes elektrisches Bauelement gekühlt werden kann.

Diese Aufgabe wird erfindungsgemäß gelöst durch einen Spannverband und durch ein Verfahren nach den unabhängigen Patentansprüchen. Vorteilhafte Ausführungsformen des Spannverbands sind in den abhängigen Patentansprüchen angegeben.

Offenbart wird eine Kühlplatte zum Kühlen eines in einem Spannverband angeordneten elektrischen Bauelements mit einem ersten Plattenteil, das aus einem Metall besteht, und einem zweiten Plattenteil, das ein Phasenwechselmaterial aufweist, wobei das erste Plattenteil und das zweite Plattenteil thermisch miteinander gekoppelt sind. Hierbei ist besonders vorteilhaft, dass die Kühlplatte (aufgrund ihrer plattenförmigen Gestalt) gut in den Spannverband eingefügt werden kann. Mittels des ersten (aus dem Metall bestehenden) Plattenteils kann vorteilhafterweise der elektrische Strom durch den Spannverband geleitet werden. Das Metall ist ein elektrisch gut leitendes Metall, beispielsweise Kupfer oder Aluminium. Mittels des zweiten (das Phasenwechselmaterial aufweisenden) Plattenteils können kurzzeitig auftretende Verlustleistungs-Wärmemengen effektiv aufgenommen und dadurch schnell von dem elektrischen Bauelement abgeführt werden.

Die Kühlplatte kann so ausgestaltet sein, dass die Kühlplatte eine kreiszylindrische Gestalt hat. Die Kühlplatte ist also eine runde Scheibe. Eine derartige kreiszylindrische Kühlplatte lässt sich besonders gut in einen Spannverband einfügen. Dies ist insbesondere dann der Fall, wenn die elektrischen Bauelemente des Spannverbands ebenfalls eine kreiszylindrische Gestalt haben.

Die Kühlplatte ist so ausgestaltet, dass das erste Plattenteil ein (radial innenliegendes) Zentrum der Kühlplatte bildet. Das erste Plattenteil bildet also einen (radial innenliegenden) inneren Teil der Kühlplatte. Mittels des das Zentrum der Kühlplatte bildenden ersten Plattenteils wird vorteilhafterweise die mechanische Stabilität des Spannverbandes sichergestellt. Die Spannkräfte wirken dabei im Wesentlichen auf dieses erste Plattenteil. Außerdem wird mit diesem (inneren) Plattenteil vorteilhafterweise der elektrische Strom durch den Spannverband und durch die elektrischen Bauelemente geleitet.

Die Kühlplatte kann so ausgestaltet sein, dass das zweite Plattenteil einen (radial außenliegenden) ringförmigen Abschnitt der Kühlplatte bildet. Mittels dieses ringförmigen zweiten Plattenteils wird vorteilhafterweise der erste Plattenteil (und damit auch das elektrisches Bauelement) gekühlt.

Die Kühlplatte ist so ausgestaltet, dass das zweite Plattenteil einen (ringförmigen) Rand der Kühlplatte bildet. Von diesem (den Rand der Kühlplatte bildenden) zweiten Plattenteil kann die aufgenommene (und kurzzeitig in dem Phasenwechselmaterial gespeicherte) Verlustleistungs-Wärmemenge vorteilhafterweise gut über Konvektion und Wärmestrahlung an die Umgebung abgegeben werden.

Die Kühlplatte kann so ausgestaltet sein, dass das zweite Plattenteil das erste Plattenteil ringförmig umgibt. Dadurch kann eine gute thermische Kopplung zwischen dem ersten Plattenteil und dem zweiten Plattenteil erreicht werden.

Die Kühlplatte kann so ausgestaltet sein, dass das erste Plattenteil aus einem metallischen Vollmaterial besteht. Mittels des metallischen Vollmaterials kann zum Einen der elektrische Strom gut durch den Spannverband geleitet werden, zum Anderen kann mittels des metallischen Vollmaterials die Wärme schnell von dem elektrischen Bauelement zu dem zweiten Plattenteil geleitet werden.

Die Kühlplatte kann so ausgestaltet sein, dass das zweite Plattenteil ein metallisches Material mit einer Vielzahl von Ausnehmungen aufweist, in denen das Phasenwechselmaterial angeordnet ist. Aufgrund der Vielzahl von Ausnehmungen in dem metallischen Material hat das Phasenwechselmaterial eine relativ große Oberfläche, so dass die Wärme schnell über das metallische Material des zweiten Plattenteils zu dem Phasenwechselmaterial transportiert und von dem Phasenwechselmaterial aufgenommen werden kann.

Die Kühlplatte kann so ausgestaltet sein, dass das zweite Plattenteil einen (offenporigen) Metallschaum aufweist, in dessen Poren das Phasenwechselmaterial angeordnet ist, oder das zweite Plattenteil eine Vielzahl von Ausnehmungen aufweist, die von metallischen Wänden begrenzt sind (Waben) und in denen das Phasenwechselmaterial angeordnet ist. Bei diesen beiden Ausgestaltungsvarianten hat das Phasenwechselmaterial eine besonders große Grenzfläche zu dem Metall, so dass die Wärme schnell von dem Metall des zweiten Plattenteils zu dem Phasenwechselmaterial transportiert werden kann und schnell von dem Phasenwechselmaterial aufgenommen werden kann. Metallschaum (geschäumtes Metall) kann zum Beispiel aus Aluminium bestehen; diese Variante ist besonders kostengünstig. Mit anderen Worten gesagt, kann das zweite Plattenteil eine metallische Tragestruktur aufweisen, die das Phasenwechselmaterial trägt. Die metallische Tragestruktur kann eine metallschaumartige Tragestruktur oder eine wabenartige Tragestruktur sein.

Offenbart wird weiterhin ein Spannverband mit einer Mehrzahl von Kühlplatten nach einer der vorstehend beschriebenen Varianten. Jede der Kühlplatten ist mindestens einem elektrischen Bauelement zugeordnet. Die Kühlplatten und die elektrischen Bauelemente sind mechanisch gegeneinander verspannt. Mittels dieses Spannverbandes können zum Einen die elektrischen Bauelemente sicher und einfach elektrisch kontaktiert werden und zum Anderen können die elektrischen Bauelemente - insbesondere beim Auftreten von kurzzeitigen erhöhten Verlustleistungen - effektiv gekühlt werden.

Der Spannverband kann so ausgestaltet sein, dass das elektrische Bauelement an das erste Plattenteil der jeweiligen Kühlplatte angrenzt (anliegt). Dadurch kann zum einen der elektrische Strom vorteilhafterweise über das erste Plattenteil (welches aus einem Metall besteht) zu dem elektrisches Bauelement geleitet werden, zum anderen kann mittels des ersten Plattenteils die Wärme schnell von dem elektrischen Bauelement abgeführt werden.

Der Spannverband kann auch so ausgestaltet sein, dass die Kühlplatten und die elektrischen Bauelemente abwechselnd in dem Spannverband angeordnet sind. So lässt sich eine Vielzahl von elektrischen Bauelementen des Spannverbandes effektiv kühlen.

Der Spannverband kann auch so ausgestaltet sein, dass die elektrischen Bauelemente jeweils von zwei Kühlplatten sandwichartig umgeben sind. Dadurch können vorteilhafterweise beide Seiten der (insbesondere scheibenförmigen) elektrischen Bauelemente gekühlt werden.

Der Spannverband kann so ausgestaltet sein, dass die elektrischen Bauelemente Überspannungsableiter, insbesondere Metalloxid-Überspannungsableiter, sind. Überspannungsableiter, insbesondere Metalloxyd-Überspannungsableiter haben oftmals eine scheibenförmige Gestalt. Daher lassen sich diese Überspannungsableiter besonders gut in einem Spannverband verbauen und mittels der Kühlplatten in dem Spannverband kühlen. Offenbart wird weiterhin ein Verfahren zum Kühlen eines in einem Spannverband angeordneten elektrischen Bauelements, bei dem
- von dem elektrischen Bauelement abgegebene Wärme (mittels Wärmeleitung) über ein erstes Plattenteil einer Kühlplatte zu einem zweiten Plattenteil der Kühlplatte geleitet wird, wobei das erste Plattenteil aus einem Metall besteht und das zweite Plattenteil ein Phasenwechselmaterial aufweist,
- durch die Wärme das Phasenwechselmaterial geschmolzen wird, wodurch die Wärme in dem Phasenwechselmaterial zwischengespeichert wird, und
- bei einem späteren Abkühlen und Erstarren des Phasenwechselmaterials frei werdende Wärme von dem zweiten Plattenteil an die Umgebung abgegeben wird.

Bei diesem Verfahren können die Kühlplatte und/oder der Spannverband gemäß den vorstehend beschriebenen Varianten ausgestaltet sein. Das Verfahren weist ebenfalls die Vorteile auf, die im Zusammenhang mit der Kühlplatte und dem Spannverband angegeben sind.

Im Folgenden wird die Erfindung anhand von Ausführungsbeispielen näher erläutert. Gleiche Bezugszeichen verweisen dabei auf gleiche oder gleich wirkende Elemente. Dazu ist in
- Figur 1: ein Ausführungsbeispiel einer Kühlplatte in einer Schnittdarstellung von oben, in
- Figur 2: die Kühlplatte der Figur 1 in einer Schnittdarstellung von der Seite, in
- Figur 3: eine Schnittdarstellung eines Ausführungsbeispiel eines Spannverbandes, in
- Figur 4: eine Schnittdarstellung einer beispielhaften Kühlplatte mit zwei elektrischen Bauelementen, in
- Figur 5 und 6: ein Ausschnitt aus einem Metallschaum eines beispielhaften zweiten Plattenteils der Kühlplatte und in
- Figur 7 und 8: ein Ausschnitt aus einem wabenförmig aufgebauten beispielhaften zweiten Plattenteil der Kühlplatte
dargestellt.

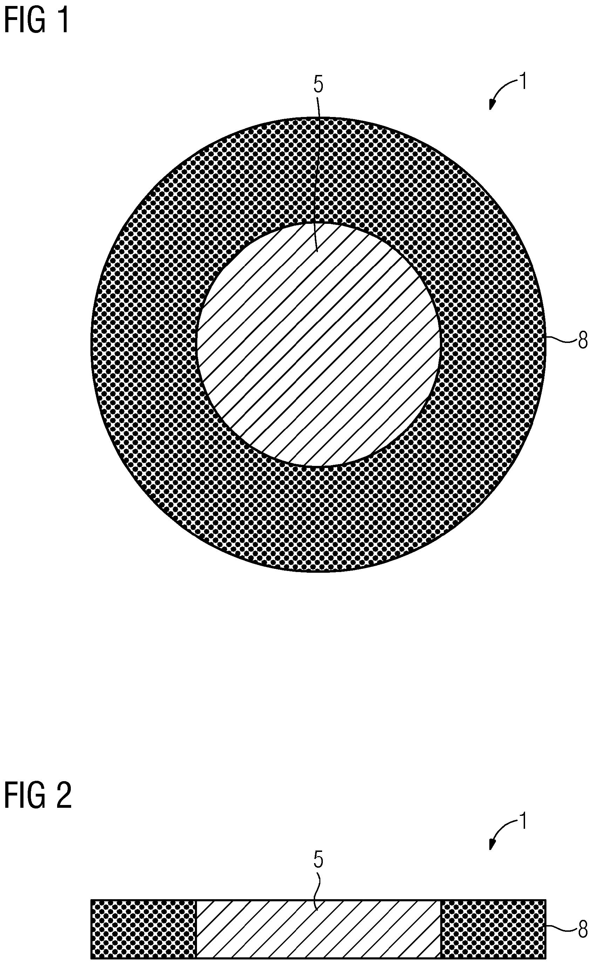

In Figur 1 ist in einer Schnittdarstellung ein Ausführungsbeispiel einer Kühlplatte 1 in einer Draufsicht dargestellt. Die Kühlplatte 1 weist ein erstes Plattenteil 5 und ein zweites Plattenteil 8 auf. Das erste Plattenteil 5 besteht aus einem Metall, genauer gesagt aus einem metallischen Vollmaterial. Dieses Metall ist ein elektrisch gut leitendes Metall wie beispielsweise Kupfer. Das zweite Plattenteil 8 weist ein Phasenwechselmaterial (phase change material, PCM) auf. Im Ausführungsbeispiel besteht das zweite Plattenteil 8 aus einem (offenporigen) Metallschaum, in dessen Poren das Phasenwechselmaterial angeordnet ist. Das erste Plattenteil 5 grenzt an das zweite Plattenteil 8 an; das erste Plattenteil 5 und das zweite Plattenteil 8 sind thermisch miteinander gekoppelt.

Die Kühlplatte 1 weist eine kreiszylindrische Gestalt auf. Mit anderen Worten ist die Kühlplatte eine runde Scheibe. Das erste Plattenteil 5 bildet ein (radial innenliegendes) Zentrum der Kühlplatte 1. Das erste Plattenteil 5 bildet also einen (radial innenliegenden) inneren Teil der Kühlplatte 1. Das zweite Plattenteil 8 bildet einen (radial außenliegenden) ringförmigen Abschnitt 8 der Kühlplatte. Dabei bildet das zweite Plattenteil 8 einen (ringförmigen) Rand der Kühlplatte. Das zweite Plattenteil 8 umgibt das erste Plattenteil 5 ringförmig.

In Figur 2 ist die Kühlplatte 1 in einer seitlichen Schnittdarstellung gezeigt.

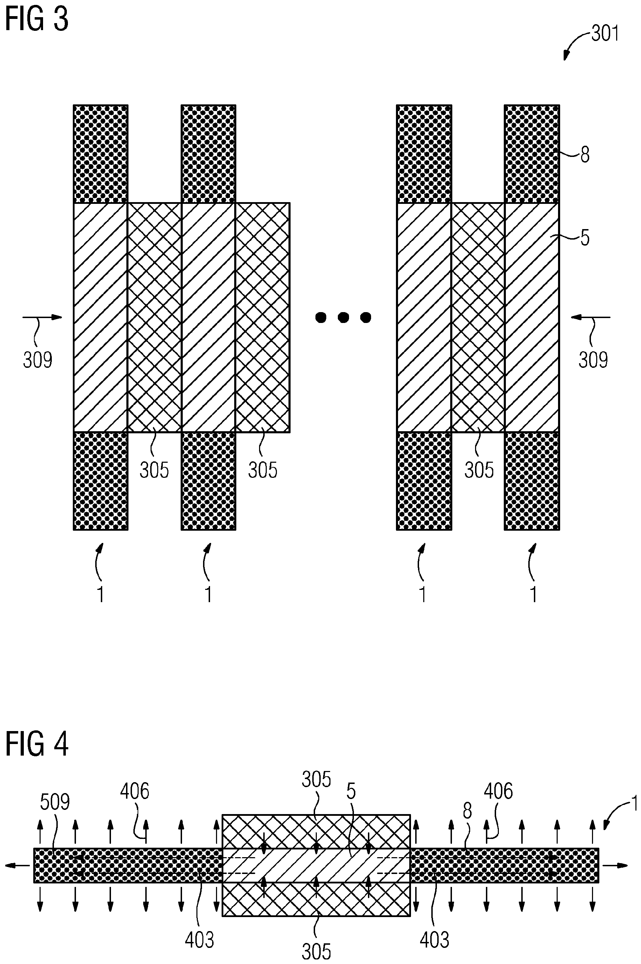

In Figur 3 ist ein Ausführungsbeispiel eines Spannverbandes 301 dargestellt. Dieser Spannverband 301 weist eine Mehrzahl von Kühlplatten 1 sowie eine Mehrzahl von elektrischen Bauelementen 305 auf. Die Kühlplatten 1 und die elektrischen Bauelemente 305 sind in dem Spannverband 301 mechanisch gegeneinander verspannt. Dies ist mittels zweier Pfeile 309, welche die extern aufgebrachten mechanischen Spannkräfte symbolisieren, angedeutet. Mittels dreier Punkte ist weiterhin angedeutet, dass der Spannverband noch weitere Kühlplatten und elektrische Bauelemente aufweisen kann.

In dem Spannverband 301 sind die Kühlplatten 1 und die elektrischen Bauelemente 305 abwechselnd angeordnet. Dabei grenzt jedes elektrische Bauelement 305 an das erste Plattenteil 5 jeweils zweier Kühlplatten 1 an. Jedes elektrische Bauelement 305 ist also von zwei Kühlplatten 1 sandwichartig umgeben. Im Ausführungsbeispiel handelt sich bei den elektrischen Bauelementen 305 um Überspannungsableiter, insbesondere um Metalloxyd-Überspannungsableiter 305. In anderen Ausführungsbeispielen kann es sich bei den elektrischen Bauelementen jedoch auch um andere Bauelemente handeln, beispielsweise um Dioden, IGCT (integrated gate-commutated thyristor) oder IGBT (insulated-gate bipolar transistor). In Figur 3 ist gut zu erkennen, dass das erste Plattenteil 5 der Kühlplatten 1 die Spannkräfte 309 aufnimmt und somit die mechanische Stabilität des Spannverbandes sicherstellt. Das erste Plattenteil 5 besteht aus einem massiven Metall (Vollmaterial). Weiterhin wird mittels des ersten Plattenteils 5 der elektrische Strom durch den Spannverband 301 und damit durch die elektrischen Bauelemente 305 geleitet. Das erste Plattenteil 5 aus metallischem Vollmaterial hat also eine Mehrfachfunktion: es stellt die mechanische Stabilität des Spannverbandes sicher, es ermöglicht den Stromfluss durch die elektrischen Bauelemente und es leitet die in den elektrisches Bauelementen entstehendes Verlustwärmemenge schnell von dem jeweiligen elektrisches Bauelement weg zu dem zweiten Plattenteil 8.

In Figur 4 ist in einer Schnittdarstellung die Kühlplatte 1 mit beiderseits der Kühlplatte angeordneten (wärmeerzeugenden) Bauelementen 305 dargestellt. Figur 4 zeigt also einen Ausschnitt aus dem Spannverband 301 der Figur 3.

Die wärmeerzeugenden Bauelemente 305 erzeugen zunächst eine elektrische Wärmemenge, welche üblicherweise beim Betrieb der Bauelemente 305 auftritt (Normalbetrieb). Diese Wärmemenge wird mittels Wärmeleitung 403 von den Bauelementen 305 über das erste Plattenteil 5 zu dem zweiten Plattenteil 8 geleitet. Diese Wärmeleitung ist mittels (im Inneren der Kühlplatte 1 angeordneter) Pfeile 403 symbolisch dargestellt. Der zweite Plattenteil 8 erwärmt sich, die Temperatur des zweiten Plattenteils 8 erreicht aber nicht die Umwandlungstemperatur des Phasenwechselmaterials. Die Umwandlungstemperatur (Phasenumwandlungstemperatur) ist diejenige Temperatur, bei der das Phasenwechselmaterial zu schmelzen beginnt. Die Umwandlungstemperatur ist materialabhängig. Die Umwandlungstemperatur kann beispielsweise 80°C betragen.

Das Phasenwechselmaterial bleibt also in seinem festen Aggregatzustand. Die Kühlplatte 1 (insbesondere der zweite Plattenteil 8 der Kühlplatte 1) gibt die Wärme langsam über Konvektion an die Umgebung ab, diese Konvektion ist durch Pfeile 406 symbolisiert. Ein kleiner Teil der Wärmemenge wird auch von der Kühlplatte bzw. von dem zweiten Plattenteil 8 als Wärmestrahlung abgestrahlt.

Nun sei angenommen, dass aufgrund eines Fehlers die Bauelemente 305 kurzzeitig eine große Wärmemenge erzeugen. Diese Wärmemenge wird durch das erste Plattenteil 5 zu dem zweiten Plattenteil 8 geleitet. Da jedoch das zweite Plattenteil 8 durch Konvektion diese Wärmemenge nur relativ langsam abgeben kann, entsteht im zweiten Plattenteil 8 (und auch im ersten Plattenteil 5) ein Wärmestau, wodurch die Temperatur des zweiten Plattenteils 8 ansteigt. Die Temperatur erreicht die Umwandlungstemperatur des Phasenwechselmaterials, wodurch das Phasenwechselmaterial zu schmelzen beginnt. Dabei nimmt das Phasenwechselmaterial eine große Wärmemenge auf (Schmelzwärme). Dadurch kann das zweite Plattenteil 8 kurzfristig eine große Wärmemenge aufnehmen, ohne dass die Temperatur des zweiten Plattenteils 8 die Umwandlungstemperatur (Schmelztemperatur) des Phasenwechselmaterials übersteigt. Die Temperatur des zweiten Plattenteils 8 steigt nicht über die Umwandlungstemperatur an, solange das Phasenwechselmaterial nicht vollständig geschmolzen ist. Die Umwandlungstemperatur muss dabei kleiner sein als die Temperatur, welche das elektrische Bauelement maximal ertragen kann, ohne dass ein Defekt auftritt.

Die Menge des Phasenwechselmaterials in dem zweiten Plattenteil 8 ist so bemessen, dass das Phasenwechselmaterial die kurzzeitigen Verlustleistungs-Maxima der Bauelemente 305 aufnehmen kann. Sobald das Bauelement 305 wieder im Normalbetrieb arbeitet und nur noch die normale Wärmemenge produziert, kühlt sich das zweite Plattenteil 8 langsam ab und gibt die in dem Phasenwechselmaterial gespeicherte Wärmemenge langsam über Konvektion 406 (und zu einem geringen Teil auch über Wärmestrahlung) an die Umgebung ab. Dabei erstarrt das Phasenwechselmaterial und geht in den festen Aggregatzustand über. Die Temperatur des zweiten Plattenteils 8 (und damit die Temperatur des Phasenwechselmaterials) sinkt unter die Umwandlungstemperatur ab und es liegen wieder die ursprünglichen Normal-Verhältnisse vor.

Das Vollmaterial des ersten Plattenteils 5 und das metallische Material des zweiten Plattenteils 8 weisen vorteilhafterweise eine hohe thermische Wärmeleitfähigkeit auf. Beispielsweise kann das Vollmaterial des ersten Plattenteils 5 aus Kupfer bestehen und das metallische Material des zweiten Plattenteils 8 kann Aluminium sein. Aus Aluminium lässt sich vorteilhafterweise sehr kostengünstig beispielsweise ein Metallschaum oder eine metallische Wabenstruktur anfertigen.

Entscheidend für die Geschwindigkeit der Phasenumwandlung des Phasenwechselmaterials und damit für die Geschwindigkeit der Wärmeaufnahme durch das zweite Plattenteil ist die Kontaktfläche zwischen dem metallischen Material des zweiten Plattenteils 8 und dem Phasenwechselmaterial. Je größer diese Kontaktfläche ist, desto schneller kann die Wärmeenergie von dem Phasenwechselmaterial aufgenommen werden und damit von den Bauelementen 305 abgeführt werden.

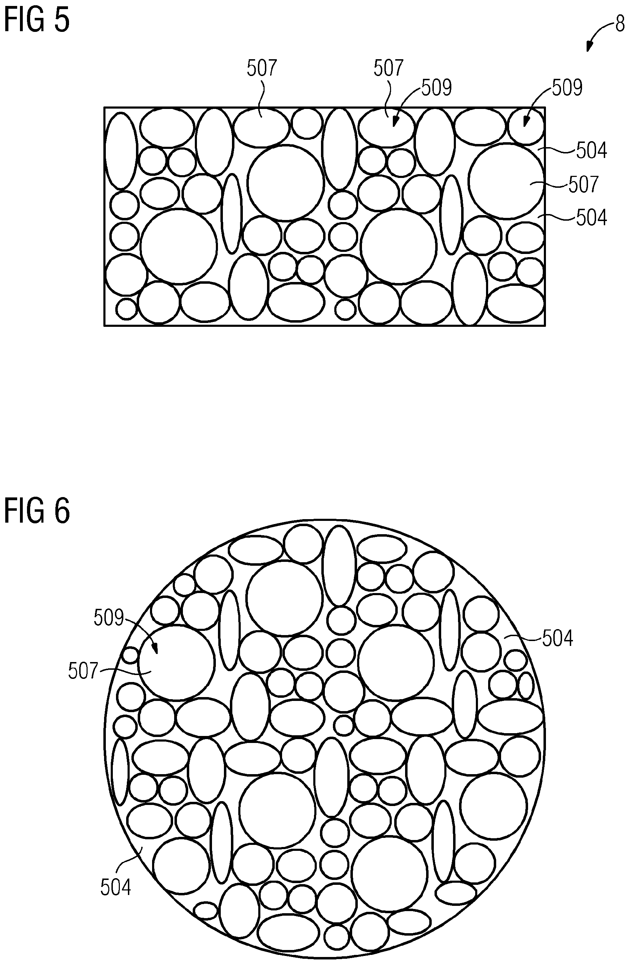

In den Figuren 5 und 6 sind in einer Schnittdarstellung von der Seite und von oben ein Ausführungsbeispiel eines Ausschnitts des zweiten Plattenteils 8 dargestellt. Es handelt sich gewissermaßen um eine Probe aus dem zweiten Plattenteil 8. Diese Probe hat nur zufällig eine kreiszylinderförmige Gestalt; dies hat nichts mit der Form des ersten Plattenteils 5 zu tun. In den Figuren 5 und 6 ist zu erkennen, dass das zweite Plattenteil 8 ein metallisches Material 504 mit einer Vielzahl von Ausnehmungen 507 aufweist. In den Ausnehmungen 507 ist Phasenwechselmaterial 509 angeordnet. Mit anderen Worten sind die Ausnehmungen 507 des metallischen Materials 504 mit dem Phasenwechselmaterial 509 gefüllt. Das metallische Material 504 bildet im Ausführungsbeispiel der Figuren 5 und 6 einen offenporigen Metallschaum 504, in dessen Poren 507 das Phasenwechselmaterial 509 angeordnet ist. Die Hohlräume (Poren) des Metallschaums sind also mit dem Phasenwechselmaterial 509 gefüllt.

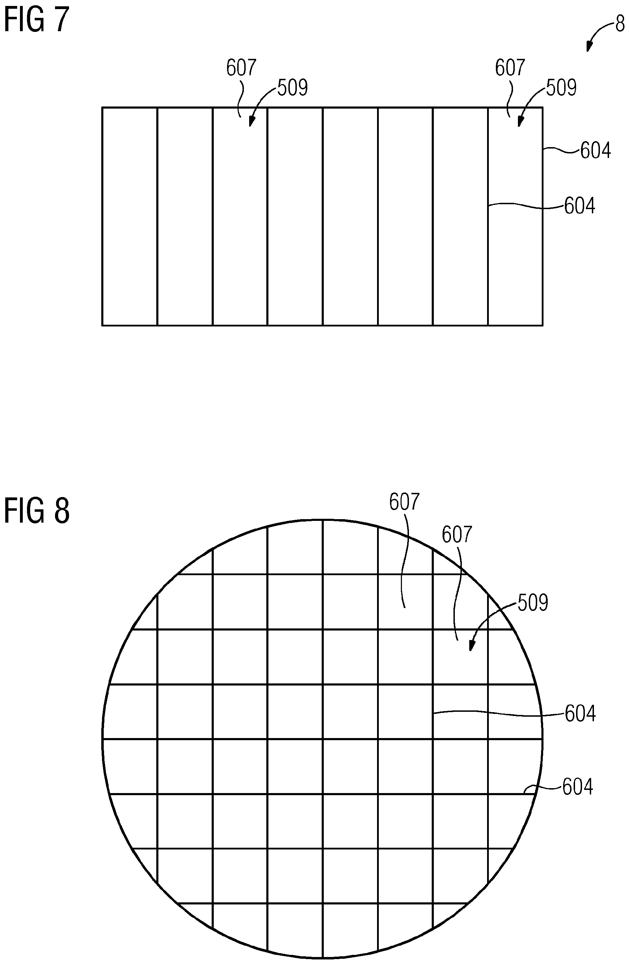

In den Figuren 7 und 8 ist in einer Schnittdarstellung von der Seite und von oben ein weiteres Ausführungsbeispiel des Materials des zweiten Plattenteils 8 dargestellt. Zu sehen ist ein metallisches Material 604, welches eine Vielzahl von Waben mit quadratischer Grundfläche bildet. Im Inneren dieser Waben befinden sich Ausnehmungen 607, die mit dem Phasenwechselmaterial 509 gefüllt sind. Das metallische Material 604 bildet also metallische Wände 604, welche die Ausnehmungen 607 begrenzen und welche das Phasenwechselmaterial 509 einschließen.

Bei den in den Figuren 5 bis 8 gezeigten Ausführungsbeispielen des Materials des zweiten Plattenteils 8 wird eine große Berührungsfläche zwischen dem Metall und dem Phasenwechselmaterial des zweiten Plattenteils 8 erreicht. Dadurch kann das Phasenwechselmaterial bei Auftreten von kurzfristigen Übertemperaturzuständen der Bauelemente relativ schnell eine große Wärmemenge aufnehmen.

Die Verwendung von Phasenwechselmaterial stellt eine kostengünstige Möglichkeit dar, das elektrische Bauelement vor kurzzeitig auftretenden thermischen Überlastungen zu schützen. Das Phasenwechselmaterial dient dabei als ein Latentwärmespeicher und kann kurzzeitig eine relativ große Wärmemenge aufnehmen und als Schmelzwärme zwischenspeichern. Phasenwechselmaterialien haben nämlich die Eigenschaft, beim Phasenwechsel von fest in flüssig große Energiemengen in Form von Wärmeenergie bei konstanter Temperatur (Phasenwechseltemperatur) aufnehmen zu können. Erst wenn das Phasenwechselmaterial komplett geschmolzen ist, tritt eine weitere Erhöhung der Temperatur auf. Da also für längere Zeit trotz Wärmeenergiezufuhr keine merkliche Temperaturerhöhung auftritt, nennt man die während des Phasenübergangs gespeicherte Energie "versteckte Wärme" oder "latente Wärme". Nach einer Unterschreitung der Umwandlungstemperatur findet dann eine Umwandlung des flüssigen Phasenwechselmaterials in festes Phasenwechselmaterial statt (Erstarrung). Dabei wird die gespeicherte Wärme relativ langsam an die Umwelt abgegeben. Phasenwechselmaterialien als solche sind bereits bekannt. Sie unterscheiden sich vor allem in ihrer Zusammensetzung, in der Umwandlungstemperatur und in der Schmelzenthalpie (Schmelzwärme, Schmelzenergie). Je nach Anwendungsfall kann also das benötigte Volumen an Phasenwechselmaterial ermittelt werden, um eine bestimmte Wärmemenge in dem Phasenwechselmaterial zu speichern und sozusagen zwischenzupuffern. Phasenwechselmaterial als solches ist gut bekannt und kann beispielsweise ein Paraffinwachs oder ein Salz mit einer geeigneten Umwandlungstemperatur (Schmelztemperatur) sein.

Es wurde eine Kühlplatte beschrieben, welche zum Kühlen eines in einem Spannverband angeordneten elektrischen Bauelements eingerichtet ist. Das zweite Plattenteil 8 der Kühlplatte 1 weist ein Phasenwechselmaterial 509 auf. Dieses Phasenwechselmaterial 509 kann schnell eine große Wärmemenge aufnehmen, die bei einem kurzzeitigen Fehlerzustand des elektrischen Bauelements entstehen kann.

## Patentansprüche

1. Spannverband (301) mit einer Mehrzahl von Kühlplatten (1) und einer Mehrzahl von elektrischen Bauelementen (305), wobei die Kühlplatten jeweils eine Kühlplatte (1) zum Kühlen eines der in dem Spannverband (301) angeordneten elektrischen Bauelemente (305) mit
- einem ersten Plattenteil (5), das aus einem Metall besteht, und
- einem zweiten Plattenteil (8), das ein Phasenwechselmaterial (509) aufweist, sind,
- wobei das erste Plattenteil (5) und das zweite Plattenteil (8) thermisch miteinander gekoppelt sind,
- das erste Plattenteil (5) ein Zentrum der Kühlplatte (1) bildet, und
- das zweite Plattenteil (8) einen Rand der Kühlplatte (1) bildet und wobei
- die Kühlplatten (1) und die elektrischen Bauelemente (305) abwechselnd in dem Spannverband (301) angeordnet sind.

2. Spannverband nach Anspruch 1,
**dadurch gekennzeichnet, dass**
- die Kühlplatte (1) eine kreiszylindrische Gestalt hat.

3. Spannverband nach einem der vorhergehenden Ansprüche,
**dadurch gekennzeichnet, dass**
- das zweite Plattenteil (8) einen ringförmigen Abschnitt der Kühlplatte (1) bildet.

4. Spannverband nach einem der vorhergehenden Ansprüche,
**dadurch gekennzeichnet, dass**
- das zweite Plattenteil (8) das erste Plattenteil (5) ringförmig umgibt.

5. Spannverband nach einem der vorhergehenden Ansprüche,
**dadurch gekennzeichnet, dass**
- das erste Plattenteil (5) aus einem metallischen Vollmaterial besteht.

6. Spannverband nach einem der vorhergehenden Ansprüche,
**dadurch gekennzeichnet, dass**
- das zweite Plattenteil (8) ein metallisches Material (504, 604) mit einer Vielzahl von Ausnehmungen (507, 607) aufweist, in denen das Phasenwechselmaterial (509) angeordnet ist.

7. Spannverband nach einem der vorhergehenden Ansprüche,
**dadurch gekennzeichnet, dass**
- das zweite Plattenteil (8) einen Metallschaum (504) aufweist, in dessen Poren (507) das Phasenwechselmaterial (509) angeordnet ist, oder
- das zweite Plattenteil (8) eine Vielzahl von Ausnehmungen (607) aufweist, die von metallischen Wänden (604) begrenzt sind und in denen das Phasenwechselmaterial (509) angeordnet ist.

8. Spannverband nach einem der vorhergehenden Ansprüche,
**dadurch gekennzeichnet, dass**
- das elektrische Bauelement (305) an das erste Plattenteil (5) der jeweiligen Kühlplatte (1) angrenzt.

9. Spannverband nach einem der vorhergehenden Ansprüche,
**dadurch gekennzeichnet, dass**
- die elektrischen Bauelemente (305) jeweils von zwei Kühlplatten (1) sandwichartig umgeben sind.

10. Spannverband nach einem der vorhergehenden Ansprüche,
**dadurch gekennzeichnet, dass**
- die elektrischen Bauelemente (305) Überspannungsableiter, insbesondere Metalloxid-Überspannungsableiter, sind.

11. Verfahren zum Kühlen eines in einem Spannverband (301) angeordneten elektrischen Bauelements (305), bei dem
- von dem elektrischen Bauelement (305) abgegebene Wärme über ein erstes Plattenteil (5) einer Kühlplatte (1) zu einem zweiten Plattenteil (8) der Kühlplatte geleitet (403) wird, wobei das erste Plattenteil (5) aus einem Metall besteht und das zweite Plattenteil (8) ein Phasenwechselmaterial (509) aufweist, das erste Plattenteil (5) ein Zentrum der Kühlplatte (1) bildet und das zweite Plattenteil (8) einen Rand der Kühlplatte (1) bildet,
- durch die Wärme das Phasenwechselmaterial (509) geschmolzen wird, wodurch die Wärme in dem Phasenwechselmaterial (509) zwischengespeichert wird, und
- bei einem späteren Abkühlen und Erstarren des Phasenwechselmaterials (509) frei werdende Wärme von dem zweiten Plattenteil (8) an die Umgebung abgegeben (406) wird, wobei
- der Spannverband eine Mehrzahl von Kühlplatten und eine Mehrzahl von elektrischen Bauelementen aufweist, und die Kühlplatten (1) und die elektrischen Bauelemente (305) abwechselnd in dem Spannverband (301) angeordnet sind.

## Claims

1. Tensioning brace (301) comprising a plurality of cooling plates (1) and a plurality of electrical components (305), wherein the cooling plates are each a cooling plate (1) for cooling one of the electrical components (305) arranged in the tensioning brace (301) and having
- a first plate portion (5) consisting of a metal, and
- a second plate portion (8) comprising a phase change material (509),
- wherein the first plate portion (5) and the second plate portion (8) are thermally coupled to one another,
- the first plate portion (5) forms a centre of the cooling plate (1), and
- the second plate portion (8) forms an edge of the cooling plate (1) and wherein
- the cooling plates (1) and the electrical components (305) are arranged alternately in the tensioning brace (301).

2. Tensioning brace according to Claim 1,
**characterized in that**
- the cooling plate (1) has a circular cylindrical shape.

3. Tensioning brace according to either of the preceding claims,
**characterized in that**
- the second plate portion (8) forms an annular section of the cooling plate (1).

4. Tensioning brace according to any one of the preceding claims,
**characterized in that**
- the second plate portion (8) annularly surrounds the first plate portion (5).

5. Tensioning brace according to any one of the preceding claims,
**characterized in that**
- the first plate portion (5) consists of a metallic solid material.

6. Tensioning brace according to any one of the preceding claims,
**characterized in that**
- the second plate portion (8) comprises a metallic material (504, 604) having a plurality of recesses (507, 607) in which the phase change material (509) is arranged.

7. Tensioning brace according to any one of the preceding claims,
**characterized in that**
- the second plate portion (8) comprises a metal foam (504), in the pores (507) of which the phase change material (509) is arranged, or
- the second plate portion (8) comprises a plurality of recesses (607) which are delimited by metallic walls (604) and in which the phase change material (509) is arranged.

8. Tensioning brace according to any one of the preceding claims,
**characterized in that**
- the electrical component (305) adjoins the first plate portion (5) of the respective cooling plate (1).

9. Tensioning brace according to any one of the preceding claims,
**characterized in that**
- the electrical components (305) are each surrounded by two cooling plates (1) in the manner of a sandwich.

10. Tensioning brace according to any one of the preceding claims,
**characterized in that**
- the electrical components (305) are surge arresters, in particular metal-oxide surge arresters.

11. Method for cooling an electrical component (305) arranged in a tensioning brace (301), in which
- heat output by the electrical component (305) is conveyed (403) via a first plate portion (5) of a cooling plate (1) to a second plate portion (8) of the cooling plate, wherein the first plate portion (5) consists of a metal and the second plate portion (8) comprises a phase change material (509), the first plate portion (5) forms a centre of the cooling plate (1) and the second plate portion (8) forms an edge of the cooling plate (1),
- the phase change material (509) is melted by the heat, as a result of which the heat is intermediately stored in the phase change material (509), and
- heat that is released upon later cooling and solidification of the phase change material (509) is output (406) from the second plate portion (8) to the surroundings, wherein
- the tensioning brace comprises a plurality of cooling plates and a plurality of electrical components, and the cooling plates (1) and the electrical components (305) are arranged alternately in the tensioning brace (301).

## Revendications

1. Assemblage (301) de serrage ayant une pluralité de plaques (1) de refroidissement et une pluralité de composants (305) électriques, dans lequel les plaques de refroidissement sont chacune une plaque (1) de refroidissement pour le refroidissement d'un composant (305) électrique disposé dans l'assemblage (301) de serrage ayant
- une première partie (5) de plaque, qui est en métal, et
- une deuxième partie (8) de plaque, qui a un matériau (509) à changement de phase,
- dans lequel la première partie (5) de la plaque et la deuxième partie (8) de la plaque sont couplées entre elles thermiquement,
- la première partie (5) de la plaque forme un centre de la plaque (1) de refroidissement et
- la deuxième partie (8) de la plaque forme un bord de la plaque (1) de refroidissement, et dans lequel
- les plaques (1) de refroidissement et les composants (305) électriques sont disposés en alternance dans l'assemblage (301) de serrage.

2. Assemblage de serrage suivant la revendication 1, **caractérisé en ce que**
- la plaque (1) de refroidissement a la forme d'un cylindre de section transversale circulaire.

3. Assemblage de serrage suivant l'une des revendications précédentes,
**caractérisé en ce que**
- la deuxième partie (8) de la plaque forme une section annulaire de la plaque (1) de refroidissement.

4. Assemblage de serrage suivant l'une des revendications précédentes,
**caractérisé en ce que**
- la deuxième partie (8) de la plaque entoure annulairement la première partie (5) de la plaque.

5. Assemblage de serrage suivant l'une des revendications précédentes,
**caractérisé en ce que**
- la première partie (5) de la plaque est en un matériau métallique plein.

6. Assemblage de serrage suivant l'une des revendications précédentes,
**caractérisé en ce que**
- la deuxième partie (8) de la plaque a un matériau (504, 604) métallique ayant une pluralité d'évidements (507, 607), dans lesquels le matériau (509) à changement de phase est mis.

7. Assemblage de serrage suivant l'une des revendications précédentes,
**caractérisé en ce que**
- la deuxième partie (8) de la plaque a une mousse (504) métallique dans les pores (507) de laquelle le matériau (509) à changement de phase est mis, ou
- la deuxième partie (8) de la plaque a une pluralité d'évidements (607), qui sont délimités par les parois (604) métalliques et dans lesquels le matériau (509) à changement de phase est mis.

8. Assemblage de serrage suivant l'une des revendications précédentes,
**caractérisé en ce que**
- le composant (305) électrique est au voisinage de la première partie (5) de la plaque (1) de refroidissement respective.

9. Assemblage de serrage suivant l'une des revendications précédentes,
**caractérisé en ce que**
- les composants (305) électriques sont entourés à la manière d'un sandwich respectivement de deux plaques (1) de refroidissement.

10. Assemblage de serrage suivant l'une des revendications précédentes,
**caractérisé en ce que**
- les composants (305) électriques sont des parafoudres, notamment des parafoudres en oxyde métallique.

11. Procédé de refroidissement d'un composant (305) électrique disposé dans un assemblage (301) de serrage, dans lequel
- on propage (403) de la chaleur cédée par le composant (305) électrique à une deuxième partie (8) d'une plaque de refroidissement, par l'intermédiaire d'une première partie (5) de la plaque (1) de refroidissement, dans lequel la première partie (5) de la plaque est en métal et la deuxième partie (8) de la plaque a un matériau (509) à changement de phase, la première partie (5) de la plaque forme le centre de la plaque (1) de refroidissement et la deuxième partie (8) de la plaque forme un bord de la plaque (1) de refroidissement,
- on fait fondre le matériau (509) à changement de phase par la chaleur, grâce à quoi on emmagasine intermédiairement la chaleur dans le matériau (509) à changement de phase, et
- lors d'un refroidissement et d'une solidification ultérieure du matériau (509) à changement de phase, on cède (406) la chaleur libérée de la deuxième partie (8) de la plaque à l'environnement, dans lequel
- l'assemblage de serrage a une pluralité de plaques de refroidissement et une pluralité de composants électriques et les plaques (1) de refroidissement et les composants (305) électriques sont disposés en alternance dans l'assemblage (301) de serrage.
